# EUROPÄISCHE PATENTSCHRIFT

(11) **EP 1 886 151 B1**
(45) Veröffentlichungstag und Bekanntmachung des Hinweises auf die Patenterteilung: **24.07.2019**
(21) Anmeldenummer: 05753537.9
(22) Anmeldetag: 02.06.2005
(51) Int. Cl.: G01R 25/02, G01R 19/25

(54) **VORRICHTUNG ZUM ERFASSEN UND VERARBEITEN EINER VIELZAHL VON MESSWERTEN IN EINER HGÜ-ANLAGE**
APPARATUS FOR DETECTING AND PROCESSING A MULTIPLICITY OF MEASURED VALUES IN AN HVDCT SYSTEM
DISPOSITIF DE DETECTION ET DE TRAITEMENT D'UNE PLURALITE DE VALEURS DE MESURE D'UNE INSTALLATION HGU

(43) Veröffentlichungstag der Anmeldung: 13.02.2008
(73) Patentinhaber: Siemens Aktiengesellschaft, 80333 München (DE)
(72) Erfinder: HÜGELSCHÄFER, Ludwig, 96052 Bamberg (DE); STRAUSS, John, 91341 Röttenbach (DE); MESSNER, Johann, 91056 Erlangen (DE); ÜNZELMANN, Günter, 91052 Erlangen (DE); GERNER, Andreas, 96450 Coburg (DE); ACKERMANN, Anja, 90587 Obermichelbach (DE)
(86) Internationale Anmeldenummer: PCT/DE2005/001027
(87) Internationale Veröffentlichungsnummer: WO 2006/128399

(56) Entgegenhaltungen:
- EP-A- 0 707 370
- EP-A- 0 736 949
- WO-A2-2004/072662
- DE-A1- 3 912 502
- US-A1- 2003 135 601
- US-B1- 6 414 958
- US-B1- 6 519 509
- US-B1- 6 636 893
- ARRILLAGA ET AL.: "Power Quality Following Deregulation" IEEE, [Online] Bd. 88, Nr. 2, - Februar 2000 (2000-02) Seiten 246-261, XP011044328 Gefunden im Internet: URL:http://140.98.193.112/iel5/5/17839/008 24002.pdf?tp=&arnumber=824002&isnumber=178 39> & MILLER A J V ET AL: "MULTICHANNEL CONTINUOUS HARMONIC ANALYSIS IN REAL-TIME" IEEE TRANSACTIONS ON POWER DELIVERY, IEEE SERVICE CENTER, NEW YORK, NY, US, Bd. 7, Nr. 4, 1. Oktober 1992 (1992-10-01), Seiten 1813-1819, XP000298192 ISSN: 0885-8977
- KURI J: "STRIPPENZIEHER MEDIENKONVERTER BRINGEN DIVERSE NETZWERKKABELTYPEN UNTER EINEN HUT", CT MAGAZIN FUER COMPUTER TECHNIK, HEISE ZEITSCHRIFTEN VERLAG, HANNOVER, DE, no. 21, 11 October 1999 (1999-10-11), pages 268-270, XP000853139, ISSN: 0724-8679
- Nn: "Network switch Contents", , 3 April 2018 (2018-04-03), XP055470345, Retrieved from the Internet: URL:https://en.wikipedia.org/wiki/Network_ switch [retrieved on 2018-04-25]
- John C. Edson , Kang Lee: "Sharing a common sense of time", IEE Instrumentation Magazine, 1 March 2003 (2003-03-01), pages 26-32, XP055524569, New York Retrieved from the Internet: URL:https://www.researchgate.net/publicati on/3420774_Sharing_a_common_sense_of_time [retrieved on 2018-11-16]

## Beschreibung

Die Erfindung betrifft eine Vorrichtung zum Erfassen und Verarbeiten einer Vielzahl von Messwerten in einer HGÜ-Anlage mit Messeinheiten zum Erfassen von Messgrößen der HGÜ-Anlage unter Gewinnung von Messwerten und mit Vorverarbeitungseinheiten.

Bei einer Hochspannungs-Gleichstromübertragungsanlage wird in einer ersten Umrichterstation aus einer mehrphasigen Wechselspannung eine Gleichspannung erzeugt. Die erste Umrichterstation ist gleichspannungsseitig mit einer zweiten Umrichtertation verbunden, welche die Gleichspannung wieder in eine mehrphasige Wechselspannung umwandelt. Der sichere Betrieb einer solchen HGÜ-Anlage macht eine Überwachung des Stromflusses und der Spannung sowohl auf der Wechselspannungsseite als auch auf der Gleichspannungsseite erforderlich. Eine Vielzahl von Messeinheiten liefert daher Messwerte der besagten Ströme und Spannungen an ein Steuerungs-, Regelungs- und Überwachungssystem. Mittels des Steuerungs-, Regelungs- und Überwachungssystems wird die gesamte Anlage zum einen überwacht, so dass in einem Fehlerfall eine schnelle und sichere Abschaltung der HGÜ-Anlage erfolgen kann. Andererseits ist das Steuerungs-, Regelungs- und Überwachungssystem für die Regelung der Umrichterstationen eingerichtet. Die Umrichterstationen umfassen eine Vielzahl von leistungselektronischen Schaltelementen, wie beispielsweise Thyristoren. Die Thyristoren müssen in Abhängigkeit der Phasenlage der Wechselspannung sehr präzise gezündet werden. In einer Steuerungseinheit wird daher aus dem von den Messeinheiten bereitgestellten mehrphasigen Wechselspannungssignal die Netzfrequenz bestimmt und in einem Phasenregelkreis die Zündzeitpunkte der Thyristoren in Anhängigkeit der Netzfrequenz berechnet. Da für die Vielzahl von Thyristoren mehrere Steuerungseinheiten benötigt werden, ist der Hardwareaufwand eines solchen Steuerungssystems sehr hoch. Darüber hinaus muss jede Steuerungseinheit Eingänge für ein mehrphasiges Wechselspannungssignal sowie die Logik zur Signalverarbeitung dieses Wechselspannungssignals beinhalten. Die einzelnen Messeinheiten sind schließlich direkt mit den jeweiligen Steuerungseinheiten zu verbinden. Dies führt zu einem sehr hohen Verkabelungsaufwand, wobei durch die Verwendung üblicher Übertragungsleitungen eine hohe Empfindlichkeit gegenüber elektromagnetischen Störungen gegeben ist.

Aus der Publikation "ARRILLAGA et al: "Power Quality Following Deregulation", IEEE, "Online", Vol. 88, Nr. 2, Februar 2000, Seiten 246-261" und der Publikation "MILLER et al: "Multichannel Continous Harmonic Analysis in Real Time", IEEE Transactions on Power Delivery, IEEE, Service Center New York, US, Nr. 4, 01.10.1992, Seiten 1813-1819" ist eine Vorrichtung zum Erfassen und Verarbeiten einer Vielzahl von Messwerten in einer HGÜ-Anlage mit Messeinheiten und Vorverarbeitungseinheiten bekannt, wobei die Vorverarbeitungseinheiten der dort offenbarten Vorrichtung jede für sich mit einer Steueruns-, Regelungs- und Überwachungseinheit verbunden sind.

Aus der US 6,519,509 B1 ist ein System zum Überwachen und Steuern von Energieverteilung für Energieversorger und Endbenutzer bekannt, bei dem Messwerte in Verarbeitungseinheiten erfasst werden.

Aus der US 6,636,893 B1 ist ein web-basiertes Energie- und Facility Management bekannt, bei dem verschiedene Verarbeitungseinheiten mit einem zentralen Managementsystem kommunizieren.

Aus der DE 39 12 502 A1 ist ein Verfahren und eine Vorrichtung zur Übertragung von Angaben zur Steuerung eines Mehrstationensystems zur Gasversorgung bekannt, bei dem mittels optischer Lichtwellenleiter Daten von einem Steuerungssystem an verschiedene Stationen übertragen werden und von den Stationen über Lichtwellenleiter zurück zum Steuerungssystem.

Aufgabe der vorliegenden Erfindung ist es, eine Vorrichtung der eingangs genannten Art so auszubilden, dass bei reduziertem Hardware- und Verkabelungsaufwand die Übertragungssicherheit und damit die Verfügbarkeit der gesamten Anlage verbessert wird.

Gelöst wird die Aufgabe durch den unabhängigen Anspruch 1 und die von diesem abhängigen Ansprüche, insbesondere dadurch, dass die Vorverarbeitungseinheiten jeweils mindestens einen optischen Eingang und mindestens zwei optische Ausgänge aufweisen, mittels Lichtwellenleitern seriell miteinander verbunden und jeweils mit wenigstens einer Messeinheit verbunden sind und die mittels einer letzten Vorverarbeitungseinheit, welche den restlichen Vorverarbeitungseinheiten nachgeschaltet ist, mittels Lichtwellenleitern mit einem Steuerungs-, Regelungs- und Überwachungssystem verbunden ist, wobei jede Vorverarbeitungseinheit zum Empfang und zur Vorverarbeitung der Messwerte mit Mitteln zur Gewinnung von optischen Daten aus den vorverarbeiteten Messwerten eingerichtet ist und sowohl zur Übertragung der von ihr erzeugten als auch der von vorgeschalteten Vorverarbeitungseinheiten empfangenen optischen Daten über die Lichtwellenleiter an eine nachgeschaltete Vorverarbeitungseinheit oder an das Steuerungs-, Regelungs- und Überwachungssystem eingerichtet ist, so dass die letzte Vorverarbeitungseinheit zur Bereitstellung sämtlicher Messwerte für das Steuerungs-, Regelungs- und Überwachungssystem ausgebildet ist. Mit einer solchen Vorverarbeitungseinheit wird zum einen der Verkabelungsaufwand der gesamten Anlage deutlich reduziert, da die einzelnen Messeinheiten nur mit ihnen zugeordneten Vorverarbeitungseinheiten verbunden werden müssen, und die einzelnen Vorverarbeitungseinheiten ihre Daten über ein optisches Bussystem an das Steuerungs-, Regelungs- und Überwachungssystem übertragen. Dadurch wird eine Reduzierung der Empfindlichkeit gegen elektromagnetische Störungen erreicht. Durch die Ausbildung der Vorverarbeitungseinheit zur Erfassung und Vorverarbeitung der ihr zugeordneten Messwerte wird gleichzeitig der Hardware-Aufwand im Steuerungs-, Regelungs- und Überwachungssystem deutlich reduziert.

Weiter weist jede Vorverarbeitungseinheit Mittel zur Frequenz- und Phasenmessung unter Vorverarbeitung von Messwerten eines mehrphasigen Wechselspannungssignals auf. Vorteilhafterweise wird die Messung von Frequenz und Phase durch eine der Vorverarbeitungseinheiten durchgeführt, so dass sämtliche Messwerte in Abhängigkeit der Phasenlage der Wechselspannung also phasensynchron an das Steuerungs-, Regelungs- und Überwachungssystem übertragbar sind. Eine Phasennachführung für jede Untereinheit des Steuerungs-, Regelungs- und Überwachungssystems entfällt im Rahmen dieser Erfindung.

Jede Vorverarbeitungseinheit ist als Mastereinheit oder als Slaveeinheit konfigurierbar. Dies ist vorteilhaft, da eine konfigurierbare Vorverarbeitungseinheit unabhängig von ihrer späteren Funktion herstellbar ist, wodurch die Herstellungskosten gesenkt werden.

Weiter weist jede Vorverarbeitungseinheit eine Vielzahl von analogen und digitalen Eingängen zur Erfassung der ihr zugeordneten Messwerte auf. Durch mindestens einen optischen Eingang und mindestens zwei optische Ausgänge ist einerseits das Ausbilden eines optischen Datenbusses zur Übertragung der Messwerte möglich, und andererseits können die Messwerte an unabhängig arbeitende Steuerungs-, Regelungs- und Überwachungssysteme mittels Lichtwellenleitern übertragen werden.

Durch die Verwendung von Lichtwellenleitern wird eine kostengünstige und sichere Übertragung der vorverarbeiteten Messwerte gewährleistet, die insbesondere unempfindlich gegen elektromagnetische Störungen ist.

In zweckmäßiger Ausgestaltung ist eine erste Vorverarbeitungseinheit, der keine Vorverarbeitungseinheit vorgeschaltet ist, als Mastereinheit konfiguriert und die der ersten Vorverarbeitungseinheit nachgeschalteten Vorverarbeitungseinheiten sind als Slaveeinheiten konfiguriert. Dies ist besonders vorteilhaft, da es ausreichend sein kann, wenn die Mastereinheit beispielsweise die Messung von Frequenz und Phase des mehrphasigen Wechselspannungssignals durchführt.

Vorteilhafterweise ist die Mastereinheit zum Erzeugen eines Synchronisationssignals für die Slaveeinheiten und das Steuerungs-, Regelungs- und Überwachungssystem ausgebildet. Beispielsweise kann die Mastereinheit aus der gemessenen Frequenz des mehrphasigen Wechselspannungssignals mittels einer Frequenzvervielfachung einen Systemtakt erzeugen, der für die Slaveeinheiten als Takt für die Vorverarbeitung der ihnen zugeordneten Messwerte dient und gleichzeitig eine synchronisierte Übertragung der vorverarbeiteten Messwerte ermöglicht.

In einer zweckmäßigen Ausgestaltung ist die Mastereinheit zum Erzeugen eines Eingangssignals für einen im Steuerungs-, Regelungs- und Überwachungssystem angeordneten Phasenregelkreis ausgebildet.

In einer bevorzugten Ausführungsform weist jede Vorverarbeitungseinheit, zusätzlich zu der Vielzahl von Eingängen für die Messwerte, Konfigurationsmittel zur Auswahl einer Funktion als Mastereinheit oder Slaveeinheit, Mittel zur Vorverarbeitung der Messwerte und elektrooptische Wandler zur Umwandlung der vorverarbeiteten Messwerte in optische Daten und Sende- und Empfangsmittel auf, wobei die Mittel zur Vorverarbeitung eine Eingangsbeschaltung zur Erfassung und Umwandlung analoger Messwerte in digitale Werte sowie ein programmierbares Gate-Array und eine digitale Signalverarbeitungseinheit umfassen. Mit einer solchen Schaltungsanordnung ist die Vorrichtung für einen flexiblen Einsatz geeignet, da durch die Verwendung von elektronischen Bauteilen wie einem programmierbaren Gate-Array und einer digitalen Signalverarbeitungseinheit, wie beispielsweise einem Digitalen Signalprozessor, eine vielseitige Verwendung, beispielsweise als Master- oder Slaveeinheit, durch einfache Änderung der Programmierung des programmierbaren Gate-Arrays oder der digitalen Signalverarbeitungseinheit möglich ist.

Vorteilhafterweise umfasst die Eingangsbeschaltung Operationsverstärker, Tiefpassfilter, Analog-/Digitalwandler und Abtastmittel. Mit einer derartigen Eingangsbeschaltung ist eine Umwandlung analoger elektronischer Signale in digitale Werte möglich, die im programmierbaren Gate-Array und in der digitalen Signalverarbeitungseinheit weiterverarbeitet werden.

In einer zweckmäßigen Ausgestaltung ist die digitale Signalverarbeitungseinheit zur Frequenzbestimmung des mehrphasigen Wechselspannungssignals ausgebildet. Dies ist besonders vorteilhaft, da mit einer digitalen Signalverarbeitungseinheit, wie beispielsweise einem digitalen Signalprozessor, eine derartige Bestimmung aus digitalen Werten einfach zu realisieren ist, und die Frequenz verwendet werden kann, um das Master-Synchronisationssignal zu erzeugen.

Die Erfindung wird anhand eines Ausführungsbeispiels mit Bezug auf die beigefügten Zeichnungen näher erläutert. Es zeigen:
- Figur 1: ein Ausführungsbeispiel der erfindungsgemäßen Vorrichtung;
- Figur 2: eine Vorverarbeitungseinheit einer Vorrichtung gemäß Fig. 1;
- Figur 3: eine schematische Darstellung der Datenverarbeitung der Vorrichtung gemäß Fig. 1.

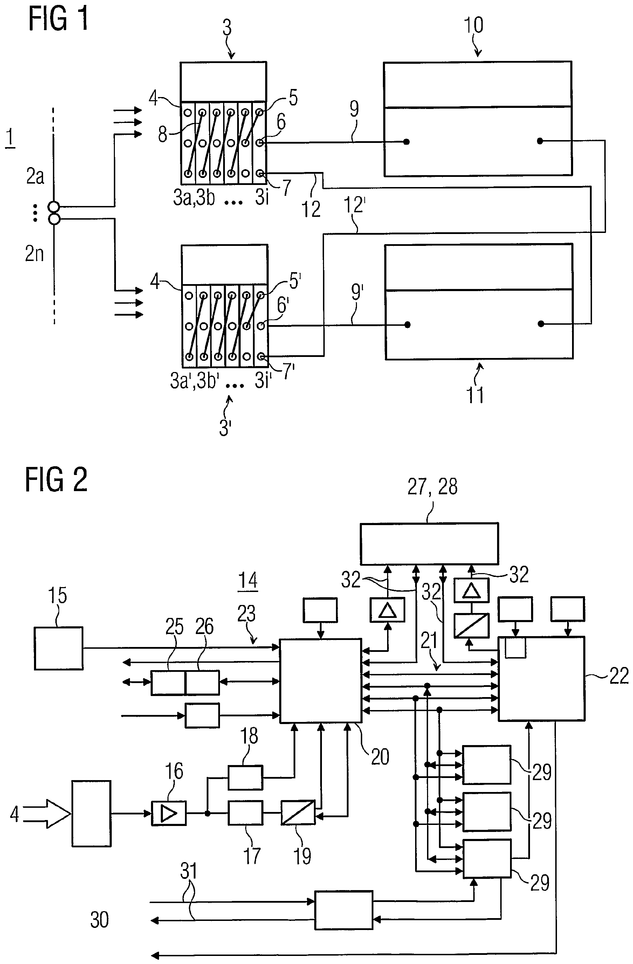

Figur 1 zeigt ein Ausführungsbeispiel der erfindungsgemäßen Vorrichtung als Teil einer Hochspannungs-Gleichstrom-übertragungsanlage (HGÜ-Anlage). Die Vorrichtung weist eine Vielzahl von Messeinheiten 2a bis 2n zur Strom- und Spannungsmessung sowohl auf der Wechselspannungs- wie auch auf der Gleichspannungsseite der HGÜ-Anlage auf, von denen in Fig. 1 nur ein redundant ausgelegter Stromwandler verdeutlicht ist, dessen Sekundärströme proportional zum Wechselstrom sind, die durch die Wechselstromsammelschiene 1 fließen. Vorverarbeitungseinheiten 3a bis 3i sind mit den Messeinheiten 2a bis 2n über Leitungen verbunden. Es ist selbstverständlich, dass eine Vorverarbeitungseinheit auch mit mehreren Messeinheiten verbunden sein kann. Die Vorverarbeitungseinheiten 3a bis 3i haben eine Eingangsschnittstelle 4 zur Verbindung mit den jeweiligen Messeinheiten, sowie optische Eingänge 5 und Ausgänge 6 und 7. Der optische Ausgang 6 einer Vorverarbeitungseinheit ist mit dem optischen Eingang 5 einer jeweiligen nächsten Vorverarbeitungseinheit über einen Lichtwellenleiter 8 verbunden. Die letzte Vorverarbeitungseinheit 3i ist an ihrem optischen Ausgang 6 über einen Lichtwellenleiter 9 mit dem Steuerungs-, Regelungs- und Überwachungssystem 10 verbunden. Der zweite optische Ausgang 7 der Vorverarbeitungseinheit 3i ist mit einem zweiten unabhängigen Steuerungs-, Regelungs- und Überwachungssystem 11 über einen weiteren Lichtwellenleiter 12 verbindbar. An den beiden optischen Ausgängen 6 und 7 der letzten Vorverarbeitungseinheit 3i werden die gleichen Messwertsätze ausgegeben. Die Verbindung des optischen Ausgangs 7 mit einem zweiten Steuerungs-, Regelungs- und Überwachungssystem 11 stellt für dieses den gleichen Messwertesatz wie für das Steuerungs-, Regelungs- und Überwachungssystem 10 zur Verfügung. Zum Bereitstellen der Redundanz sind die Messeinheiten 2a bis 2n mit einer zweiten Anordnung von Vorverarbeitungseinheiten 3a' bis 3i' verbunden. Durch die seriell miteinander verbundenen Vorverarbeitungseinheiten 3a bis 3i sowie die ebenfalls seriell miteinander verbundenen Vorverarbeitungseinheiten 3a' bis 3i' stehen damit zwei voneinander unabhängige Messsysteme 3 und 3' zur Verfügung. Der optische Ausgang 6 der Vorverarbeitungseinheit 3i des ersten Messsystems 3 ist mit dem optischen Eingang des Steuerungs-, Regelungs- und Überwachungssystems 10 verbunden, der optische Ausgang 7 der Vorverarbeitungseinheit 3i mit einem zweiten Steuerungs-, Regelungs- und Überwachungssystem 11. Der optische Ausgang 6' der Vorverarbeitungseinheit 3i' des zweiten Messsystems 3' ist mit dem optischen Eingang des Steuerungs-, Regelungs- und Überwachungssystems 11 verbunden. Der optische Ausgang 7' der Vorverarbeitungseinheit 3' ist mit einem zweiten optischen Eingang des Steuerungs-, Regelungs- und Überwachungssystems 10 verbunden. Mit einer derartigen Anordnung unabhängiger Messsysteme 3 und 3' sowie unabhängigen Steuerungs-, Regelungs- und Überwachungssysteme 10 und 11 ist eine vollkommen redundante Steuerung und Überwachung einer Hochspannungsgleichstromübertragungsanlage möglich, da beim Ausfall eines der Messsysteme 3 oder 3' ein weiteres Messsysteme zur Verfügung steht, ebenso wie bei Ausfall eines der Steuerungs-, Regelungs- und Überwachungssysteme 10 oder 11 noch eine weiteres Steuerungs-, Regelungs- und Überwachungssystem zur Verfügung steht. Ein derartiger redundanter Aufbau der Mess- und Steuerungs-, Regelungs- und Überwachungssysteme führt zu einer deutlich verbesserten Verfügbarkeit und Sicherheit der gesamten Anlage. Aus der Figur 1 wird erkennbar, dass die Verwendung einer erfindungsgemäßen Vorverarbeitungseinheit zu einem erheblich reduzierten Verkabelungsaufwand und damit zu einer deutlich reduzierten Empfindlichkeit gegenüber elektromagnetischen Störungen führt, da bei dieser Anordnung die Vorverarbeitungseinheiten über einen optischen Datenbus mit den Steuerungs-, Regelungs- und Überwachungssystemen verbunden sind. Ohne die Verwendung der erfindungsgemäßen Vorverarbeitungseinheiten müsste hingegen jede der Messeinheiten 2a bis 2n mit den jeweiligen Steuerungs-, Regelungs- und Überwachungssystemen 10 und 11 verbunden werden, wodurch neben dem erhöhten Verkabelungsaufwand auch der Hardwareaufwand für die Steuerungs-, Regelungs- und Überwachungssysteme enorm ansteigen würde, da die Steuerungs-, Regelungs- und Überwachungssysteme ein Vielfaches an Eingängen für die einzelnen Messeinheitensignale benötigen würden. Die Steuerungs-, Regelungs- und Überwachungssysteme 10 und 11 sind über eine nicht dargestellte Leitungsanordnung mit regelbaren Bauteilen der HGÜ-Anlage verbunden.

In Figur 2 ist der Aufbau einer erfindungsgemäßen Vorverarbeitungseinheit 14 dargestellt. Die Vorverarbeitungseinheit 14 umfasst ein Konfigurationsmittel 15, mit dem die Funktion der Vorverarbeitungseinheit als Mastereinheit oder Slaveeinheit einstellbar ist, sowie eine Eingangsschnittstelle 4 mit analogen Eingängen und eine Eingangsbeschaltung mit einem Operationsverstärker 16, einem Tiefpassfilter 17, Abtastmittel 18 sowie einen Analog-/Digitalwandler 19 angeordnet. Ein mit der Eingangsbeschaltung verbundenes programmierbares Gatearray 20 ist über Datenleitungen 21 mit einer digitalen Signalverarbeitungseinheit 22, wie beispielsweise einem digitalen Signalprozessor 22, sowie über weitere Leitungen 23 mit optoelektronischen Wandlern 25 und elektrooptischen Wandlern 26 zum Senden und Empfangen von optischen Daten verbunden. Die Vorverarbeitungseinheit 14 umfasst ferner eine Reihe von Diagnosemitteln 27 bis 30 mit Kommunikationsleitungen 31, 32. Über die Kommunikationsleitungen 31, 32 der Diagnosemittel kann bei Bedarf eine neue Programmierung des programmierbaren Gate-Arrays 20 oder der digitalen Signalverarbeitungseinheit 22 oder bei einer Störung eine Fehlersuche bzw. Fehlerdiagnose erfolgen.

Die Eingangsbeschaltung mit Operationsverstärker 16, Abtastmittel 18, Tiefpassfilter 17 und Analog-/Digitalwandler 19 dient zur Umwandlung der analog empfangenen Daten in digitale Messwerte, die im programmierbaren Gatearray 20 und im digitalen Signalprozessor 22 verarbeitet werden. Über das programmierbare Gatearray 20 werden die digitalen Messwerte an den digitalen Signalprozessor 22 weitergeleitet, in welchem eine Auswertung und Vorverarbeitung erfolgt. Der digitale Signalprozessor 22 bestimmt aus den Messwerten die Frequenz der gemessenen Wechselspannung sowie Strom- und Spannungswerte und gibt diese über die Datenleitungen 21 an das programmierbare Gatearray 20 zurück. Das programmierbare Gatearray 20 kann über den optischen Busanschluss 24 und einen optoelektronischen Wandler 26 Daten von anderen Vorverarbeitungseinheiten empfangen und zwischenspeichern. Im programmierbaren Gatearray 20 werden die vom digitalen Signalprozessor 22 erhaltenen Messwerte zusammen mit den von anderen Vorverarbeitungseinheiten empfangenen Messwerten zu einem Messwertesatz zusammengefügt und über einen elektrooptischen Wandler 25 an den optischen Busanschluss 24 zur weiteren Datenübertragung an eine nächste Vorverarbeitungseinheit oder das Steuerungs-, Regelungs- und Überwachungssystem gesendet.

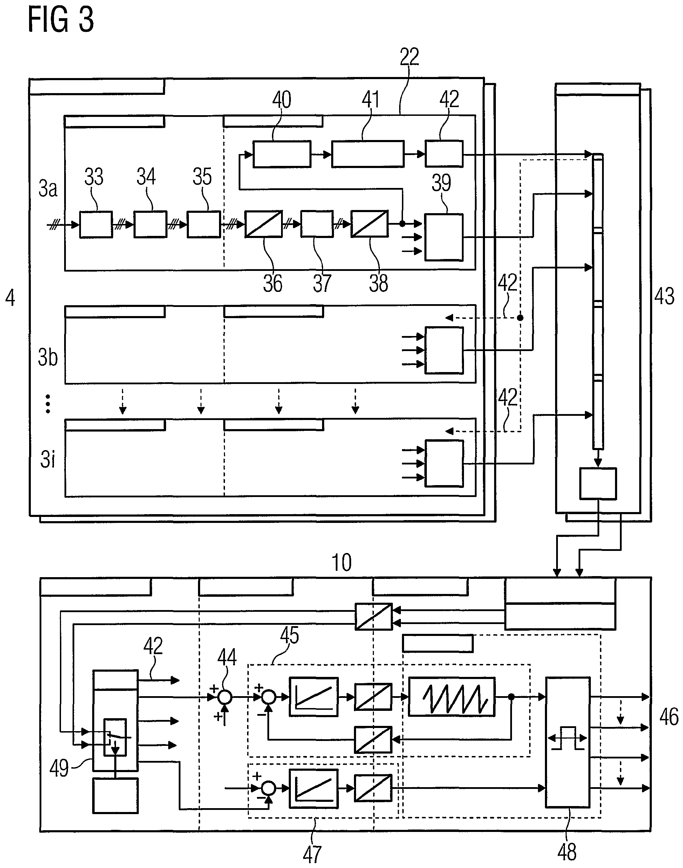

Figur 3 zeigt eine schematische Darstellung der Vorverarbeitung der Messwerte durch die Vorverarbeitungseinheiten 3a...3i und die Datenübertragung an das Steuerungs-, Regelungs- und Überwachungssystem. Die von den Messeinheiten übertragenen Messwerte werden von nicht dargestellten Transducern in verarbeitbare Spannungen überführt und einem Antialiasingfilter 33 zugeleitet, der mit einem A/D-Wandler 34 zum Abtasten und Digitalisieren der Messwerte verbunden ist. Anschließend werden die Daten mittels Tiefpass 35 zur Unterdrückung störender Hochfrequenzanteile bearbeitet. In der digitalen Signalverarbeitungseinheit 22 werden die digitalen Daten vorverarbeitet, indem durch eine Transformation 36 des dreiphasigen Signals in ein zweiphasiges Signal und weitere Filterung 37 die Phasenlage 38 der Signale sowie weitere Werte, wie beispielsweise Amplituden und Beträge der Signale berechnet werden. Die derartig vorverarbeiteten Daten liegen als Messwerte 39 zur Übertragung an das Steuerungs-, Regelungs- und Überwachungssystemsystem vor.

In der Figur 3 ist die erste Vorverarbeitungseinheit 3a als Mastereinheit konfiguriert, die weiteren Vorverarbeitungseinheiten 3b bis 3i als Slaveeinheiten. Bei der Mastereinheit 3a werden in der digitalen Signalverarbeitungseinheit 22 zusätzliche Verarbeitungsschritte durchgeführt. Nach der oben beschriebenen Bestimmung der Phasenlage 38 des Wechselspannungssignals findet in der Mastereinheit 3a eine Frequenzmessung 40 des Wechselspannungssignals statt, an die sich eine Frequenzvervielfachung durch einen Frequenzvervielfacher 41 anschließt. Hierbei wird die gemessene Frequenz des Wechselspannungssignals mit einem Faktor 128 multipliziert. Diese vervielfachte Frequenz dient als Taktfrequenz für die digitale Signalverarbeitung in den einzelnen Slaveeinheiten 3b...3i sowie für die Datenübertragung an das Steuerungs-, Regelungs- und Überwachungssystem und die dortige weitere Verarbeitung. Durch die Vervielfachung um einen Faktor 128 ist damit eine Abtastung des Wechselspannungssignals mit 128 Werten pro Periode des Wechselspannungssignals ermöglicht. Die Mastereinheit 3a erzeugt ein Master-Synchronisationssignal 42 anhand des aus der vervielfachten Frequenz berechneten Systemtaktes, welches an die weiteren Slaveeinheiten 3b bis 3i übertragen wird, so dass diese durch das Master-Synchronisationssignals 42 getaktet werden. Anhand des in der Mastereinheit 3a erzeugten Systemtaktes findet die digitale Signalverarbeitung wie oben beschrieben in den einzelnen Slaveeinheiten 3b...3i statt. Gleichzeitig dient das Master-Synchronisationssignal 42 zur Synchronisierung der Datenübertragung der einzelnen Vorverarbeitungseinheiten 3a...3i über den optischen Datenbus 43 an das Steuerungs-, Regelungs- und Überwachungssystem 10. Im Steuerungs-, Regelungs- und Überwachungssystem 10 werden die optischen Messdatenwerte 39 in digitale elektronische Signale umgewandelt. Aus der in der Vorverarbeitungseinheit 3a bestimmten Frequenz des Wechselspannungssignals wird, nachdem ein Korrekturfaktor 44 für die Phase, der sich aus der zur Berechnung und Vorverarbeitung sowie zur Übertragung benötigten Zeit ergibt, in einem Phasenregelkreis 45 die Ansteuerung für die leistungselektronischen Schaltelemente berechnet. Dazu wird in dem Phasenregelkreis 45 die Abweichung zwischen der gemessenen Phase des Wechselspannungssignals und der Phase eines regelbaren Oszillator bestimmt und der Oszillator entsprechend der Abweichung nachgeführt, so dass am Ausgang 46 des Phasenregelkreises 45 ein an die gemessene Frequenz angepasstes Signal anliegt, mit dem eine präzise Ansteuerung der leistungselektronischen Schaltelemente der HGÜ-Anlage erfolgen kann. Zur Verarbeitung der aus den Vorverarbeitungseinheiten übertragenen Daten sind naturgemäß im Steuerungs-, Regelungs- und Überwachungssystem weitere Verarbeitungs-, Steuerungs- und Regelelemente, die hier schematisch mit Bezugszeichen 47, 48, 49 bezeichnet sind, angeordnet.

### Bezugszeichenliste

- 1: Wechselstromsammelschiene
- 2a bis 2n: Messeinheiten
- 3a bis 3i: Vorverarbeitungseinheiten
- 4: Eingangsinterface
- 5: digitaloptischer Eingang
- 6, 7: digitaloptische Ausgänge
- 8: Lichtwellenleiter
- 9: Lichtwellenleiter
- 10: Steuerungs-, Regelungs- und Überwachungssystem
- 11: Steuerungs-, Regelungs- und Überwachungssystem
- 12: Lichtwellenleiter
- 13: Leitungsanordnung
- 14: Vorverarbeitungseinheit
- 15: Konfigurationsmittel
- 16: Operationsverstärker
- 17: Tiefpassfilter
- 18: Abtastmittel
- 19: Analogdigitalwandler
- 20: programmierbares Gatearray
- 21: Datenleitungen
- 22: digitaler Signalprozessor
- 23: Leitungen
- 25: elektrooptischer Wandler
- 26: optoelektronischer Wandler
- 27 bis 30: Diagnosemittel
- 31, 32: Kommunikationsleitungen
- 33: Antialiasingfilter
- 34: A/D-Wandler
- 35: Tiefpassfilter
- 36: Transformation
- 37: Filterung
- 38: Phasenlage
- 39: Messdatenwerte
- 40: Frequenzmessung
- 41: Frequenzvervielfachung
- 42: Master-Synchronisationssignal
- 43: optischer Datenbus
- 44: Phasenkorrektur
- 45: Phasenregelkreis
- 46: Ausgang
- 47,48,49: Verarbeitungs-, Steuerungs- und Regelelemente

## Patentansprüche

1. Vorrichtung zum Erfassen und Verarbeiten einer Vielzahl von Messwerten in einer HGÜ-Anlage mit Messeinheiten (2a...2n) zum Erfassen von Messgrößen der HGÜ-Anlage unter Gewinnung von Messwerten und Vorverarbeitungseinheiten,
wobei
jede Vorverarbeitungseinheit (3a...3i) Mittel (20,22) zur Frequenz- und Phasenmessung eines mehrphasigen Wechselspannungssignals aufweist, wobei die Messung von Frequenz und Phase durch eine der Vorverarbeitungseinheiten (3a...3i) durchgeführt wird, so dass sämtliche Messwerte in Abhängigkeit der Phasenlage der Wechselspannung also phasensynchron an das Steuerungs-, Regelungs- und Überwachungssystem (10,11) übertragbar sind, jede Vorverarbeitungseinheit (3a...3i) als Mastereinheit (3a) oder als Slaveeinheit (3b...3i) konfigurierbar ist, die Vorverarbeitungseinheiten (3a...3i) jeweils eine Vielzahl von analogen (4) und digitalen Eingängen zur Erfassung und Vorverarbeitung der ihr zugeordneten Messwerte, mit mindestens einem optischen Eingang (5), und mindestens zwei optische Ausgänge (6,7) zur Übertragung der Messwerte aufweisen, mittels Lichtwellenleitern (8, 9) seriell miteinander verbunden und jeweils mit wenigstens einer Messeinheit (2a...2n) verbunden sind und die mittels einer letzten Vorverarbeitungseinheit (3i), welche den restlichen Vorverarbeitungseinheiten nachgeschaltet ist, mittels Lichtwellenleitern (8,9) mit einem Steuerungs-, Regelungs- und Überwachungssystem (10,11) verbunden ist, wobei jede Vorverarbeitungseinheit (3a...3i) zum Empfang und zur Vorverarbeitung der Messwerte unter Gewinnung von optischen Messwerten eingerichtet ist und sowohl zur Übertragung der von ihr erzeugten als auch der von vorgeschalteten Vorverarbeitungseinheiten empfangenen optischen Messwerten über die Lichtwellenleiter an eine nachgeschaltete Vorverarbeitungseinheit oder an das Steuerungs-, Regelungs- und Überwachungssystem (10,11) eingerichtet ist, so dass die letzte Vorverarbeitungseinheit zur Bereitstellung sämtlicher Messwerte für das Steuerungs-, Regelungs- und Überwachungssystem (10,11) ausgebildet ist, wobei die letzte Vorverarbeitungseinheit (3i) an ihrem optischen Ausgang (6) über einen Lichtwellenleiter (9) mit dem Steuerungs-, Regelungs- und Überwachungssystem (10) verbunden ist und der zweite optische Ausgang (7) der Vorverarbeitungseinheit (3i) mit einem zweiten unabhängigen Steuerungs-, Regelungs- und Überwachungssystem (11) über einen weiteren Lichtwellenleiter (12) verbindbar ist.

2. Vorrichtung nach Anspruch 1,
**dadurch gekennzeichnet, dass**
eine erste Vorverarbeitungseinheit (3a), der keine Vorverarbeitungseinheit vorgeschaltet ist, als Mastereinheit konfiguriert ist und die der ersten Vorverarbeitungseinheit nachgeschalteten Vorverarbeitungseinheiten (3b...3i) als Slaveeinheiten konfiguriert sind.

3. Vorrichtung nach Anspruch 2,
**dadurch gekennzeichnet, dass**
die Mastereinheit (3a) zum Erzeugen eines Synchronisationssignals für die Slaveeinheiten (3b...3i) und das Steuerungs-, Regelungs- und Überwachungssystem (10) ausgebildet ist.

4. Vorrichtung nach Anspruch 3,
**dadurch gekennzeichnet, dass**
die Mastereinheit (3a) zum Erzeugen eines Eingangssignals für einen im Steuerungs-, Regelungs- und Überwachungssystem (10) angeordneten Phasenregelkreis (45) ausgebildet ist.

5. Vorrichtung nach einem der vorhergehenden Ansprüche, **dadurch gekennzeichnet, dass**
jede Vorverarbeitungseinheit (3a...3i) Konfigurationsmittel (15) zur Auswahl einer Funktion als Mastereinheit oder Slaveeinheit, Mittel (16,17,18,19,20,21,22) zur Vorverarbeitung der Messwerte und elektrooptische Wandler (25) zur Umwandlung der vorverarbeiteten Messwerte in optische Daten und Sende- und Empfangsmittel aufweist, wobei die Mittel zur Vorverarbeitung (16,17,18,19,20,21,22) eine Eingangsbeschaltung (16,17,18,19) zur Erfassung und Umwandlung analoger Messwerte in digitale Werte sowie ein programmierbares Gate-Array (20) und eine digitale Signalverarbeitungseinheit (22) umfassen.

6. Vorrichtung nach Anspruch 5, **dadurch gekennzeichnet, dass** die Eingangsbeschaltung Operationsverstärker (16), Tiefpassfilter (17), Abtastmittel (18) und Analog-/Digitalwandler (19) umfasst.

7. Vorrichtung nach einem der Ansprüche 1 bis 6, **dadurch gekennzeichnet, dass**
an den beiden optischen Ausgängen (6, 7) der letzten Vorverarbeitungseinheit (3i) die gleichen Messwertsätze ausgegeben werden, wobei die Verbindung des optischen Ausgangs (7) mit dem zweiten Steuerungs-, Regelungs- und Überwachungssystem (11) für dieses den gleichen Messwertesatz wie für das Steuerungs-, Regelungs- und Überwachungssystem (10) zur Verfügung stellt, wobei zum Bereitstellen der Redundanz die Messeinheiten (2a...2n) mit einer zweiten Anordnung von Vorverarbeitungseinheiten (3a'...3i') verbunden sind und durch die seriell miteinander verbundenen Vorverarbeitungseinheiten (3a...3i) sowie die ebenfalls seriell miteinander verbundenen Vorverarbeitungseinheiten (3a'...3i') damit zwei voneinander unabhängige Messsysteme (3...3') zur Verfügung stellt.

## Claims

1. Apparatus for detection and processing of a multiplicity of measured values in an HVDC transmission installation having measurement units (2a...2n) for detection of measurement variables in the HVDC transmission installation, with measured values being obtained, and preprocessing units, wherein each preprocessing unit (3a...3i) has means (20, 22) for frequency and phase measurement of a polyphase AC voltage signal, wherein the measurement of frequency and phase is carried out by one of the preprocessing units (3a...3i), such that all the measured values are able to be transmitted to the open-loop control, closed-loop control and monitoring system (10, 11) depending on the phase angle of the AC voltage, that is to say phase-synchronously, each preprocessing unit (3a...3i) can be configured as a master unit (3a) or as a slave unit (3b...3i), the preprocessing units (3a...3i) each have a multiplicity of analog (4) and digital inputs for detection and preprocessing of the measured values associated with them, having at least one optical input (5), and at least two optical outputs (6, 7) for transmission of the measured values, are connected in series with one another by means of optical waveguides (8, 9) and are each connected to at least one measurement unit (2a...2n) and are connected by means of optical waveguides (8, 9) to an open-loop control, closed-loop control and monitoring system (10, 11) by means of a final preprocessing unit (3i), which is connected downstream from the other preprocessing units, with each preprocessing unit (3a...3i) being designed to receive and to preprocess the measured values with optical measured values being obtained, and being designed both to transmit the optical measured values which are produced by it and the optical measured values received from upstream preprocessing units via the optical waveguides to a downstream preprocessing unit or to the open-loop control, closed-loop control and monitoring system (10, 11) such that the final preprocessing unit is configured to provide all the measured values for the open-loop control, closed-loop control and monitoring system (10, 11), wherein the final preprocessing unit (3i) is able to be connected, at its optical output (6), to the open-loop control, closed-loop control and monitoring system (10) via an optical waveguide (9) and the second optical output (7) of the preprocessing unit (3i) is able to be connected to a second independent open-loop control, closed-loop control and monitoring system (11) via a further optical waveguide (12) .

2. Apparatus according to Claim 1, **characterized in that** a first preprocessing unit (3a), which is not preceded by any other preprocessing unit, is configured as a master unit, and those preprocessing units (3b...3i) which are connected downstream from the first preprocessing unit are configured as slave units.

3. Apparatus according to Claim 2, **characterized in that** the master unit (3a) is designed to produce a synchronization signal for the slave unit (3b...3i) and the open-loop control, closed-loop control and monitoring system (10).

4. Apparatus according to Claim 3, **characterized in that** the master unit (3a) is designed to produce an input signal for a phase locked loop (45) which is arranged in the open-loop control, closed-loop control and monitoring system (10).

5. Apparatus according to one of the preceding claims, **characterized in that** each preprocessing unit (3a...3i) has configuration means (15) for selection of a function as a master unit or slave unit, means (16, 17, 18, 19, 20, 21, 22) for preprocessing of the measured values and electro-optical transducers (25) for conversion of the preprocessed measured values to optical data and transmitting and receiving means, with the means for preprocessing (16, 17, 18, 19, 20, 21, 22) having input circuitry (16, 17, 18, 19) for detection and conversion of analog measured values to digital values, as well as a programmable gate array (20) and a digital signal processing unit (22).

6. Apparatus according to Claim 5, **characterized in that** the input circuitry comprises operational amplifiers (16), low-pass filters (17), sampling means (18) and analog/digital converters (19).

7. Apparatus according to one of Claims 1 to 6, **characterized in that** the same measured-value sets are output at the two optical outputs (6, 7) of the last preprocessing unit (3i), wherein the connection of the optical output (7) to the second open-loop control, closed-loop control and monitoring system (11) provides the same measured-value set for this system as for the open-loop control, closed-loop control and monitoring system (10), wherein in order to provide redundancy, the measurement units (2a...2n) are connected to a second arrangement of preprocessing units (3a'...3i') and two mutually independent measurement systems (3...3') are thus provided by the preprocessing units (3a...3i), which are connected in series with one another, and the preprocessing units (3a'...3i'), which are likewise connected in series with one another.

## Revendications

1. Dispositif de détection et de traitement d'une pluralité de valeurs de mesure dans une installation de courant continu à haute tension, ayant des unités (2a...2n) de mesure pour détecter des grandeurs de mesure de l'installation de courant continu à haute tension, en obtenant des valeurs de mesure et des unités de traitement préalable, dans lequel chaque unité (3a...3i) de traitement préalable à des moyens (20, 22) de mesure de la fréquence et de la phase d'un signal de tension alternative polyphasée, la mesure de la fréquence et de la phase étant effectuée par l'une des unités (3a...3i) de traitement préalable, de manière à ce que l'ensemble des valeurs de mesure puisse être transmis, en fonction de la position en phase de la tension alternative, donc en synchronisme de phase, au système (10, 11) de commande de réglage et de contrôle, chaque unité (3a...3i) de traitement préalable pouvant être configurée en unité (3a) maître ou en unité (3b...3i) esclave, les unités (3a...3i) de traitement préalable ayant chacune une pluralité d'entrées analogiques (4) et numériques pour détecter et traiter au préalable les valeurs de mesure qui leur sont associées, avec au moins une entrée (5) optique, et au moins deux sorties (6, 7) optiques de transmission des valeurs de mesure sont reliées entre elles en série au moyen de guides (8, 9) d'ondes lumineuses et sont reliées respectivement à au moins une unité (2a...2n) de mesure et qui, au moyen d'une dernière unité (31) de traitement préalable, qui est montée en aval du reste des unités de traitement préalable, est reliée au moyen de guides (8, 9) d'ondes lumineuses à un système (10, 11) de commande, de réglage et de contrôle, chaque unité (3a...3i) de traitement préalable étant conçue pour la réception et le traitement préalable des valeurs de mesure, en obtenant des valeurs de mesure optique, et tant pour la transmission des valeurs de mesure optique qu'elle produit qu'également elle reçoit des unités de traitement préalable en amont, par l'intermédiaire des guides d'ondes lumineuses à une unité de traitement préalable en aval ou au système (10, 11) de commande, de réglage et de contrôle, de manière à ce que la dernière unité de traitement préalable soit constituée pour la mise à disposition de l'ensemble des valeurs de mesure pour le système (10, 11) de commande, de réglage et de contrôle, la dernière unité (3i) de traitement préalable étant, sur sa sortie (6) optique par l'intermédiaire d'un guide (9) d'ondes lumineuses, reliée au système (10) de commande, de réglage et de contrôle et la deuxième sortie (7) optique de l'unité (3i) de traitement préalable pouvant être reliée à un deuxième système (11) indépendant de commande, de réglage et de contrôle par l'intermédiaire d'un autre guide (12) d'ondes lumineuses.

2. Dispositif suivant la revendication 1,
**caractérisé en ce que**
une première unité (3a) de traitement préalable, en amont de laquelle une unité de traitement préalable n'est pas montée, est configurée en unité maître et les unités (3a...3i) de traitement préalable montées en aval de la première unité de traitement préalable sont configurées en unités esclaves.

3. Dispositif suivant la revendication 2,
**caractérisé en ce que**
l'unité (3a) maître est configurée pour produire un signal de synchronisation des unités (3b...3i) esclaves et du système (10) de commande, de réglage et de contrôle.

4. Dispositif suivant la revendication 3,
**caractérisé en ce que**
l'unité (3a) maître est constituée pour produire un signal d'entrée pour un circuit (45) de réglage de phase monté dans le système (10) de commande, de réglage et de contrôle.

5. Dispositif suivant l'une des revendications précédentes,
**caractérisé en ce que**
chaque unité (3a...3i) de traitement préalable a des moyens (15) de configuration pour choisir une fonction comme unité maître ou unité esclave, des moyens (16, 17, 18, 19, 20, 21 22) de traitement préalable des valeurs de mesure et un transducteur (25) électro-optique pour transformer les valeurs de mesure traitées au préalable en des données optiques et des moyens d'émission et de réception, les moyens de traitement préalable (16, 17, 18, 19, 20, 21, 22) comprenant un circuit (16, 17, 18, 19) d'entrée pour détecter et transformer des valeurs de mesure analogiques en des valeurs numériques, ainsi qu'un circuit (20) prédiffusé programmable et une unité (22) de traitement du signal numérique.

6. Dispositif suivant la revendication 5, **caractérisé en ce que** le circuit d'entrée comprend des amplificateurs (16) opérationnels, des filtres passe-bas, des moyens (18) d'échantillonnage et un convertisseur (19) analogique/ numérique.

7. Dispositif suivant l'une des revendications 1 à 6,
**caractérisé en ce que**
aux deux sorties (6, 7) optiques de la dernière unité (3i) de traitement préalable sont émis les mêmes jeux de valeurs de mesure, la liaison de la sortie (7) optique au deuxième système (11) de commande, de réglage et de contrôle mettant à disposition de celui-ci le même jeu de valeurs de mesure que pour le système (10) de commande, de réglage et de contrôle, dans lequel, pour procurer la redondance, les unités (2a...2n) de mesure sont reliées à un deuxième dispositif d'unités (3a'...3i') de traitement préalable et, par les unités (3a...3i) de traitement préalable, montées entre elles en série, ainsi que par les unités (3a'...3i') de traitement préalable montées entre elles également en série, il est mis ainsi à disposition deux systèmes (3...3') de mesure indépendants l'un de l'autre.
